# EUROPEAN PATENT APPLICATION

(11) **EP 4 700 978 A1**
(43) Date of publication of application: **25.02.2026**
(21) Application number: 24195139.1
(22) Date of filing: 19.08.2024
(51) Int. Cl.: H01P 5/02, H01L 23/66, H01Q 1/22, H04B 5/72

(54) **CHIP TO CHIP DIRECT PROXIMITY WIRELESS COUPLING**

(71) Applicant: INTEL Corporation, Santa Clara, CA 95054 (US)
(72) Inventor: YANG, Tae-Young, Portland, 97229 (US); YAMADA, Shuhei, Vancouver, 98684 (US); ACIKALIN, Tolga, San Jose (US); ZHOU, Zhen, Chandler, 85248 (US); FOUST, Kenneth, Beaverton, 97007 (US); HORINE, Bryce, Portland, 97229 (US); SKINNER, Harry, Beaverton, 97006 (US)
(74) Representative: Viering, Jentschura & Partner mbB Patent- und Rechtsanwälte

(57) **Abstract**

Disclosed herein are devices, systems, and methods related to edge couplers for providing wireless channel interconnects between edges of chiplets, components, modules, devices, packages, SoCs, etc. Such edge couplers may be formed from a stack of multiple layers and a core arranged between layers of the stack. A driven via extends from at least one feed layer of the stack of multiple layers into the core, wherein the driven via is isolated from ground. A plurality of grounded through-hole vias are grounded, extend from at least one ground layer of the stack, and traverse through the core, wherein the plurality of grounded through-hole vias partially surround the driven via.

## Description

### Technical Field

The disclosure relates generally to direct proximity wireless connections between components such as chiplets, modules, devices, packages, printed circuit boards (PCBs), system-on-chip (SoC), etc., and in particular, to wireless edge couplers that may provide for contactless edge coupling among such components.

### Background

In computing systems, connections between components within the system (e.g., multiple chips, SoCs, or chiplets mounted together and/or on a PCB) typically rely on wired interconnects for communication among components of the system. The Universal Chiplet Interconnect Express (UCIe) standard was developed to standardize these interconnects and foster interoperability among components from different manufacturers. However, UCIe faces challenges such as a developing ecosystem, potential performance bottlenecks, complex integration, chiplet count given placement limitations, and slow industry adoption.

As demand grows for low-latency, high-throughput, and efficient chip-to-chip communication, proprietary connection schemes have been developed as alternatives to UCIe. As chiplet density increases, minimizing chiplet distances becomes more important, which increases signal routing complexity for wired connection, particularly as chiplet disaggregation leads to larger package sizes and warpage constraints necessitate smaller packages. As a result, existing wired solutions may not be sufficient.

### Brief Description of the Drawings

In the drawings, like reference characters generally refer to the same parts throughout the different views. The drawings are not necessarily to scale, emphasis instead generally being placed upon illustrating the exemplary principles of the disclosure. In the following description, various exemplary aspects of the disclosure are described with reference to the following drawings, in which:
FIG. 1 shows an example plot of the trade-off relationships for different designs of an edge coupler in terms of coupler height;
FIG. 2 shows an example cross-sectional view of an overall system in which silicon-based edge couplers may be used;
FIG. 3 illustrates an example stack-up of an edge coupler formed from a stack of layers that surround a silicon-based core;
FIG. 4 illustrates an example geometry and dimensions of a two-component system, where each component has two edge couplers for communicating over two respective channels between the two components;
FIG. 5 depicts simulation results of the silicon-based 2x2x1 system of direct proximity couplers of FIG. 4;
FIG. 6 depicts parametric simulation results of gap distance versus channel loss versus isolation of the silicon-based 2x2x1 system of direct proximity couplers of FIG. 4;
FIG. 7 shows example geometry and dimensions of a two-component system, where each component has four edge couplers for communicating over four corresponding channels between the two components;
FIG. 8 shows simulation results of the 2x4x1 direct proximity coupler array of FIG. 7;
FIG. 9 illustrates a simulated electric-field distribution of the 2x4x1 direct proximity coupler array of FIG. 7;
FIG. 10 illustrates visually how a top metal block may be integrated into the coupler to provide vertical current cancelation;
FIG. 11 depicts visually how a slot stub may be integrated into the coupler to provide horizontal current cancelation;
FIG. 12 depicts an example of an overall cross-sectional view of a direct proximity coupling channel between two vertically polarized contactless couplers;
FIG. 13 shows an overall stack-up of glass-based core of a direct proximity channel coupler;
FIG. 14 shows a 2x2x1 array of glass-based direct proximity couplers, where each coupler is covered on the top layer with a current cancelation metal block;
FIG. 15 illustrates the 2x2x1 array of glass-based direct proximity couplers of FIG. 14, where the top metal block is transparent to reveal the driven blind via and grounded through-hole vias that surround the driven via of each coupler;
FIG. 16 illustrates simulation results of s-parameters of a 2x2x1 array of glass-based direct proximity couplers with and without leakage current cancellation (e.g., a top metal block and/or slot stub(s);
FIG. 17 depicts a 2x4x1 array of glass-based direct proximity couplers, where each coupler is covered on the top layer with a current cancelation metal block;
FIG. 18 depicts example simulation results for the 2x4x1 array of the glass-based direct proximity couplers of FIG. 17;
FIG. 19 shows two views of a 2x2x3 array of glass-based direct proximity couplers , where each stack of couplers is covered on the top with a current cancelation metal block;
FIG. 20 shows simulation results for the 2x2x3 glass-based direct proximity couplers of FIG. 19 for point-to-point communications;
FIG. 21 illustrates simulation results for the 2x2x3 glass-core based direct proximity couplers of FIG. 19 for broadcast communications;
FIG. 22 illustrates two views of a 2x4x3 array of glass-based direct proximity couplers, where each stack of couplers is covered on the top with a current cancelation metal block;
FIGs. 23 and 24 depict various examples of the communication capabilities of the 2x4x3 array of FIG. 22 for point-to-point communications or broadcast communications, as well as the point-to-point interference that may result;
FIG. 25 depict an example of a direct proximity coupling channel between a coupler formed in a monolithic die and coupler formed in non-monolithic die;
FIG. 26 shows an example of a direct proximity coupling channel for die-to-die communications, where the couplers' transmission channels are between dies that are formed on a common substrate;
FIG. 27 shows an example of a 3D heterogeneous chiplet integration of a direct proximity coupling channel with a 3D stacked package of high bandwidth memory (HBM) dynamic random access memory (DRAM) dies and a compute die;
FIG. 28 illustrates an example 3D heterogeneous chiplet integration of a direct proximity coupling channel and EMIB in the package; and
FIG. 29 illustrates an example 3D heterogeneous chiplet integration of a stack of direct proximity coupling channels and EMIB in the package.

### Description

The following detailed description refers to the accompanying drawings that show, by way of illustration, exemplary details and features.

The word "exemplary" is used herein to mean "serving as an example, instance, or illustration." Any aspect or design described herein as "exemplary" is not necessarily to be construed as preferred or advantageous over other aspects or designs.

Throughout the drawings, it should be noted that like reference numbers are used to depict the same or similar elements, features, and structures, unless otherwise noted.

The phrase "at least one" and "one or more" may be understood to include a numerical quantity greater than or equal to one (*e.g*., one, two, three, four, [...], etc.). The phrase "at least one of" with regard to a group of elements may be used herein to mean at least one element from the group consisting of the elements. For example, the phrase "at least one of" with regard to a group of elements may be used herein to mean a selection of: one of the listed elements, a plurality of one of the listed elements, a plurality of individual listed elements, or a plurality of a multiple of individual listed elements.

The words "plural" and "multiple" in the description and in the claims expressly refer to a quantity greater than one. Accordingly, any phrases explicitly invoking the aforementioned words (*e.g*., "plural [elements]", "multiple [elements]") referring to a quantity of elements expressly refers to more than one of the said elements. For instance, the phrase "a plurality" may be understood to include a numerical quantity greater than or equal to two (*e.g*., two, three, four, five, [...], etc.).

The phrases "group (of)", "set (of)", "collection (of)", "series (of)", "sequence (of)", "grouping (of)", etc., in the description and in the claims, if any, refer to a quantity equal to or greater than one, i.e., one or more. The terms "proper subset", "reduced subset", and "lesser subset" refer to a subset of a set that is not equal to the set, illustratively, referring to a subset of a set that contains less elements than the set.

The term "data" as used herein may be understood to include information in any suitable analog or digital form, *e.g*., provided as a file, a portion of a file, a set of files, a signal or stream, a portion of a signal or stream, a set of signals or streams, and the like. Further, the term "data" may also be used to mean a reference to information, *e.g*., in the form of a pointer. The term "data", however, is not limited to the aforementioned examples and may take various forms and represent any information as understood in the art.

The terms "processor" or "controller" as, for example, used herein may be understood as any kind of technological entity (e.g., hardware, software, and/or a combination of both) that allows handling of data. The data may be handled according to one or more specific functions executed by the processor or controller. Further, a processor or controller as used herein may be understood as any kind of circuit, e.g., any kind of analog or digital circuit. A processor or a controller may thus be or include an analog circuit, digital circuit, mixed-signal circuit, software, firmware, logic circuit, processor, microprocessor, Central Processing Unit (CPU), Graphics Processing Unit (GPU), Neural Processing Unit (NPU), Digital Signal Processor (DSP), Field Programmable Gate Array (FPGA), integrated circuit, Application Specific Integrated Circuit (ASIC), etc., or any combination thereof. Any other kind of implementation of the respective functions, which will be described below in further detail, may also be understood as a processor, controller, or logic circuit. It is understood that any two (or more) of the processors, controllers, or logic circuits detailed herein may be realized as a single entity with equivalent functionality or the like, and conversely that any single processor, controller, or logic circuit detailed herein may be realized as two (or more) separate entities with equivalent functionality or the like.

As used herein, "memory" is understood as a computer-readable medium (*e.g*., a non-transitory computer-readable medium) in which data or information can be stored for retrieval. References to "memory" included herein may thus be understood as referring to volatile or non-volatile memory, including random access memory (RAM), read-only memory (ROM), flash memory, solid-state storage, magnetic tape, hard disk drive, optical drive, 3D XPoint^{™}, among others, or any combination thereof. Registers, shift registers, processor registers, data buffers, among others, are also embraced herein by the term memory. The term "software" refers to any type of executable instruction, including firmware.

Unless explicitly specified, the term "transmit" encompasses both direct (point-to-point) and indirect transmission (via one or more intermediary points). Similarly, the term "receive" encompasses both direct and indirect reception. Furthermore, the terms "transmit," "receive," "communicate," and other similar terms encompass both physical transmission (*e.g*., the transmission of radio signals) and logical transmission (*e.g*., the transmission of digital data over a logical software-level connection). For example, a processor or controller may transmit or receive data over a software-level connection with another processor or controller in the form of radio signals, where the physical transmission and reception is handled by radio-layer components such as radio frequency (RF) transceivers and antennas, and the logical transmission and reception over the software-level connection is performed by the processors or controllers. The term "communicate" encompasses one or both of transmitting and receiving, i.e., unidirectional or bidirectional communication in one or both of the incoming and outgoing directions. The term "calculate" encompasses both "direct" calculations via a mathematical expression/formula/relationship and 'indirect' calculations via lookup or hash tables and other array indexing or searching operations. References to the TX/RX "chain" or "path" refer to the series of processing steps to convert, modulate, amplify, filter, etc. the data signal to be transmitted (along the TX path) from the antenna or to the series of processing steps to convert, modulate, amplify, filter, etc. the desired signal (along the RX path) that is to be recovered from the received signal at the antenna. References to a "desired" signal refer to the predefined signal that is to be received by the communication device at the prescribed time.

As noted above, wired interconnects between chiplets, SoCs, devices, packages, PCBs, etc. may impose limitations on chiplet density and chiplet proximity within a given computing system. Wired interconnects, therefore, may be insufficient to handle dense designs, where chiplet disaggregation leads to larger package sizes and warpage constraints necessitate smaller packages. To overcome the constraints of wired connections, several alternative technologies have been developed such as silicon interposer-based interconnects, embedded multi-die interconnect bridge (EMIB), bumpless signal-coupling concept, waveguide interconnects, and baseband direct proximity coupling channel coils, each of which are discussed in more detail below.

With silicon interposer-based interconnects, they provide signal routing between chiplets through redistribution layers on silicon interposer and that also connect to package layers using through-silicon vias (TSVs or grounded through-hole vias). Examples of silicon interposer-based interconnects include UltraFusion^{®} and 3DFabric^{®} which are technologies that leverage more advanced chip stacking and packaging approaches, but they are essentially built on top of the classic silicon interposer approach. The high cost associated with silicon interposers is a significant barrier to their widespread adoption in 3D heterogeneous chiplet integration. The size of the dies that may be connected may also be constrained by the maximum dimensions of the silicon interposer that may be manufactured, which in turn limits the flexibility in combining different dies. As should be appreciate, not all of them may fit onto the interposer.

Moreover, as the need for more interconnects to link additional chiplets increases, the size of the interposer may exceed the limits of a photolithography reticle. Consequently, the interposer would have to be divided into smaller pieces, which shifts the interconnect challenges down to the packaging level. In short, the use of silicon interposers may not be a scalable solution. These issues are inherent to any interposer-based interconnect approach.

With embedded multi-die interconnect bridge (EMIB), it uses silicon bridges embedded in package for connecting chiplets. Another example is Intel^{®} Foveros^{®}, which is the face-to-face (F2F) chip-on-chip bonding through extremely fine-pitched micro-bumps to enable 3D die stacking packaging process technology. EMIB and Foveros^{®} and are very efficient interconnect technologies for 2.5D integration and even for low level 3D integration, whereby "top" dies are placed above a "base" die. But these technologies may not scale well for massive 3D integration because the data rate per signal line may be limited to the 2 to 10 Gbps range. To create an aggregate data transport of, say, 1 Tbps between chiplets, 100 to 500 transmission lines with extremely fine pitch may be needed, which increases design complexity and reduces yields. Thus, the cost further increases. In addition, extra bumps and package area may be needed for connecting the chiplets.

With the bumpless signal-coupling concept, the die contains RF circuitry that generates a high-frequency signal. This signal is transferred from a horizontally polarized tapered slot antenna (e.g., a waveguide launcher) into a waveguide structure without going through bumps and an interposer. The waveguide may be a surface-mount component. Multiple waveguides may be grouped as a network. Horizontally polarized tapered slot antenna (TSA) may be placed in a metal layer of die to operate as a launcher for coupling to a waveguide structure. A TSA may act like a traveling-wave antenna and provide ultrawideband performance if the antenna length is approximately 3 to 10 wavelengths (e.g., 3.7 - 12.2 mm at 110 GHz inside in a silicon backend), which may be too large to be practical. In addition, metal patterns in top and bottom layers of the TSA should be located at quarter wavelengths (e.g. +/- ~300 µm at 110 GHz) in order not to cancel out the radiating currents on TSA. Given that the overall height of metal layers of silicon backend is typically less than 20 µm and bump height is about 50 µm, and hence the operational bandwidth of horizontally polarized TSA in the metal layers of die may be limited to that of a single-resonant antenna. Thus, a horizontally polarized TSA fundamentally suffers from the electrically large size requirement and narrow-bandwidth issue.

With waveguide interconnects, such as the Embedded Waveguide Interconnect Bridge (EWIB), these may be used for point-to-point communications and for direct coupling of broadcast channels. However, the closer the chiplets are, the more complex the signal routing may become, even for waveguide interconnects. This may be especially problematic as larger numbers of disaggregated chiplets lead to increased package sizes, where package warpage constraints limit the maximum size, often necessitating division into smaller packages.

With baseband direct proximity coupling channel coils, a direct proximity coupling channel may use a coil-shaped structure for coupling over a direct channel. However, this design may be limited to baseband communications, which may constrain its operational bandwidth. Coil-shaped structures have been primarily focused on vertical wireless input/output (WIO) for stacked thin silicon layers, such as high bandwidth memory (HBM), which utilizes broadside communications. Horizontal WIO applications, requiring end-fire communications, have been largely excluded due to the technical hurdles associated with coil-based WIO. These technical hurdles include a very limited communication range and poor coupling efficiency, as coils predominantly link through broadside magnetic flux coupling. Considering, for example, a 90-degree rotated coil pair to address this issue is challenging, as there are no natural materials that effectively enable magnetic conductor reflector, and creating a broadband artificial magnetic conductor with engineered materials is highly complex. Moreover, coil-based WIO systems are most efficient for baseband communication below the coil's self-resonant frequency and are not well-suited for pass-band communications which could enable a wider operational bandwidth.

Different from the above listed interconnects, disclosed herein is a direct proximity coupling wireless input/output (WIO) interconnect that may provide a cost-effective approach for interconnecting chiplets, especially as larger numbers of disaggregated chiplets lead to increased package sizes. Package warpage constraints limit the maximum size, often necessitating division into smaller packages, which further underscores the potential utility of the disclosed direct proximity coupling WIO.

The disclosed direct proximity coupling WIO may provide ultra-wideband, vertically polarized, high-isolation contactless couplers and WIO architectures that leverage direct proximity coupling couplers. These couplers may be located at the edge of components, such as chiplets, dies, packages, modules, PCBs, in order to provide interconnects to nearby/adjacent components. Passband communication links may be made through direct proximity coupling mechanism between the couplers without employing a bridge structure, lens, waveguide, and/or any passive and active stricture/circuit. A high-isolation level (> 35 dB) between adjacent couplers may allow for arranging couplers in an array on an edge of a package and aggregate data throughputs of the coupler elements in the array. The disclosed couplers may be constructed using grounded through-hole vias and a driven via (e.g., a blind via or other terminating via that is isolated from ground on one end) to provide vertically polarized, high-isolation contactless couplers that may cover the entire G-band (e.g., 110 - 300 GHz) and/or the entire D-band (e.g., 110 - 170 GHz). The disclosed couplers may support both point-to-point communication and vertical broadcast capabilities in an *l* × *m* × *n* coupler array architecture. Although D-band and G-band examples are presented in this disclosure, the disclosed couplers and WIO architectures are frequency scalable, where the dimensions may be adjusted as a function of the desired operating frequency band.

The disclosed couplers may provide greater than 35 dB stream-to-stream isolation that enables data throughput aggregation with a channel array. The disclosed couplers may support up to 150-µm (e.g., 75-µm) chiplet-to-chiplet gap distance for high data throughputs (e.g., greater than 150 Gbps) with D-band (and/or G-band or other bands) as an implementation example. The disclosed couplers may provide greater than 150-µm chiplet-to-chiplet gap distance, with design trade-offs in data throughputs and channel pitches. The disclosed couplers may support both point-to-point and vertical broadcast communications. The disclosed couplers may reduce latency, reduce wire routing congestion and additional insertion loss, address the excessive complexity and topological limitations of wired interconnects. The disclosed couplers may reduce the number of bumps and package balls, providing a potential path to reduce package size. The disclosed couplers may allow for flexible floor planning of 3-D integrated products to alleviate thermal/mechanical constraints and reduce time to market. The disclosed couplers may be easy to implement with high-volume manufacturing feasibility. The disclosed couplers may enable scalable heterogeneous chiplet integration, unlocking energy-efficient and cost-effective artificial intelligence (AI) accelerators.

The disclosed couplers may be passband couplers that may provide direct proximity couple channels that are based on linear polarizations (e.g., vertical, horizontal, etc.), circular polarization, or elliptical polarization. Horizontally polarized couplers may suffer from electric current cancellations due to electromagnetic boundary conditions imposed by metallic objects in proximity, including an integrated heat spreader (IHS). Thus, horizontally polarized couplers may experience issues, such as narrow operational bandwidth and low efficiency. Because circular and elliptical polarizations are a superposition of horizontal and vertical polarizations, circular/elliptical polarized couplers may have a maximum of 3 dB extra channel loss, compared to that of vertically polarized couplers.

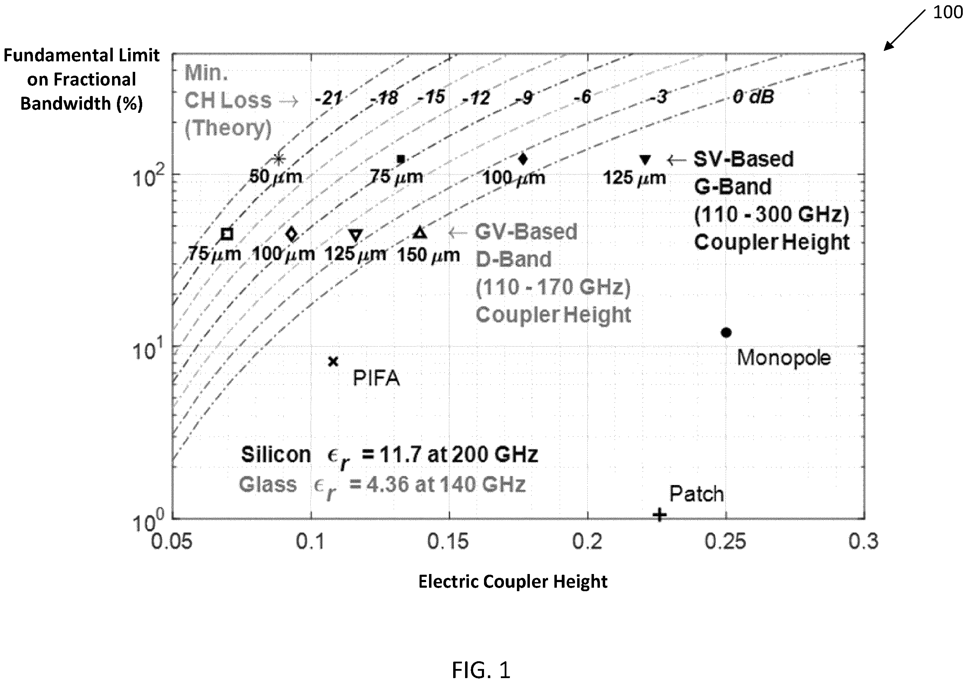

In view of these potential shortcomings, a vertically polarized coupler may be preferred for passband direct proximity coupling channels. FIG. 1 shows an exemplary plot 100 of the trade-off relationships for different designs of the disclosed coupler in terms of electrical sub-THz coupler height vs. fundamental limit on fractional bandwidth vs. theoretical minimum channel loss (e.g. for arriving at an optimum coupler height, minimum channel loss, and maximum operational bandwidth) for both glass and silicon-based coupler cases.

FIG. 1 is based on the fundamental limit theory on antennas. As should be understood, glass-based couplers may be mainly targeted for D-band (e.g., 110 - 170 GHz) inter-chiplet communications while silicon-based couplers may be targeted for G-band (e.g., 110 - 300 GHz) inter-package/PCB/module communications. The divided frequency bands between silicon and glass may be due to their dielectric constant difference and the corresponding physical footprint of couplers and parasitic resonances limiting operational frequency range. These parasitic resonances may often create a deep frequency notch in the middle of the targeted operational frequency range.

As suggested by FIG. 1, it may be impractical to consider a silicon/glass-based coupler with less than 50 µm height due to the significant > 20 dB channel loss. For example, the tolerable channel loss for D-band may be approximately 22 dB to achieve > 150 Gbps data throughput, considering the overall losses from transceivers, transmit/receive switch, electrostatic discharge (ESD) protection circuit, and extra impedance matching blocks. While the analytic analysis provided in FIG. 1 assumes no material/ohmic loss and coupling loss between couplers, practical couplers with < 50 µm height may practically experience several dBs extra loss on top of the theoretical minimum channel loss. In this sense, it may be desirable to start with the physical coupler height close to zero channel loss curve to achieve an acceptable trade-off between coupler height, channel loss, and bandwidth. Based on the analytic analysis results of FIG. 1, for example, a 150-µm height may be a good starting point for a D-band, glass-based coupler design while a 120-µm height may be a good starting point for a G-band, silicon-based coupler design.

The analytic analysis plot of FIG. 1 may also be used for benchmarking. A few samples of the well-known coupler types, such as monopole, patch, and planar inverted-F antenna (PIFA), have been included in the plot. These types of couplers are not even close to the limit curves. As should be understood, while D-band and G-band examples are used throughout this disclosure, the disclosed couplers and WIO architectures are frequency scalable, as suggested based on the analytical curves in plot 100 of FIG. 1.

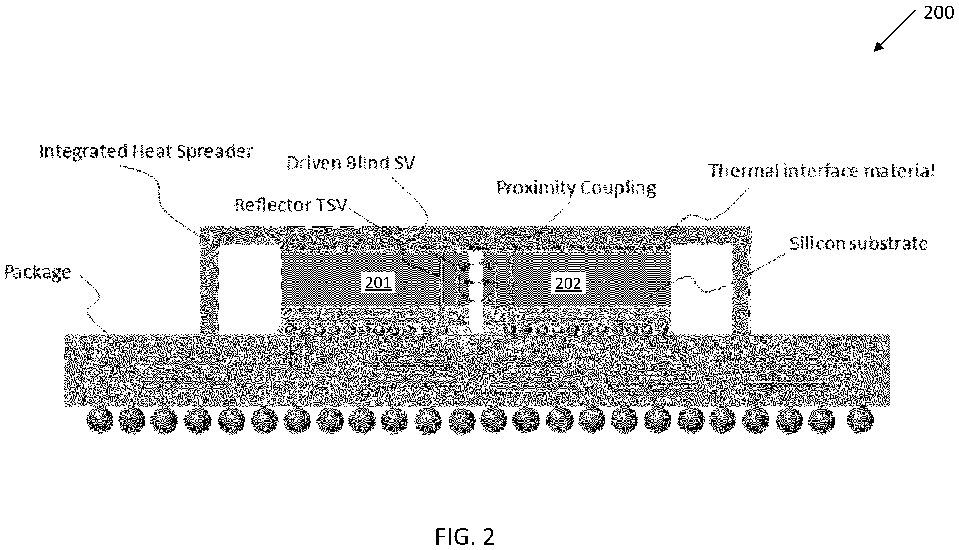

FIG. 2 shows a cross-sectional view of an overall system 200 in which silicon-based couplers may be used. The system 200 may include a chiplet 201 and a chiplet 202 that may be mounted on a package and surrounded by an integrated heat spreader that couples to the tops of chiplet 201 and chiplet 202 through a thermal interface material (TIM). Each of chiplet 201 and chiplet 202 may include an edge coupler at the edge of the respective chiplet that includes a driven via (e.g., blind via, blind silicon via (BSV), blind glass via (BGV), or other via that is open-ended and not grounded) that is surrounded by reflective grounded through-hole vias to direct the radiation pattern from the driven via toward the corresponding edge of the neighboring chiplet. This forms a direct proximity coupling channel between chiplet 201 and chiplet 202 via the vertically polarized contactless couplers in a monolithic die. For example, analog and RF circuit blocks included in each of the chiplets 201 and 201 may transmit and/or receive sub-THz signals (e.g., transceivers in the metal layers of the silicon die on the package of the chiplet). These transceivers may be connected to the vertically polarized edge coupler in the silicon substrate of each chiplet. Both monolithic and non-monolithic dies may be used. Each coupler in the chiplet may be formed by a single driven via (e.g., also called a blind silicon via (BSV), if monolithic silicon die is used, or a blind glass via (BGV), if a monolithic glass die is used).

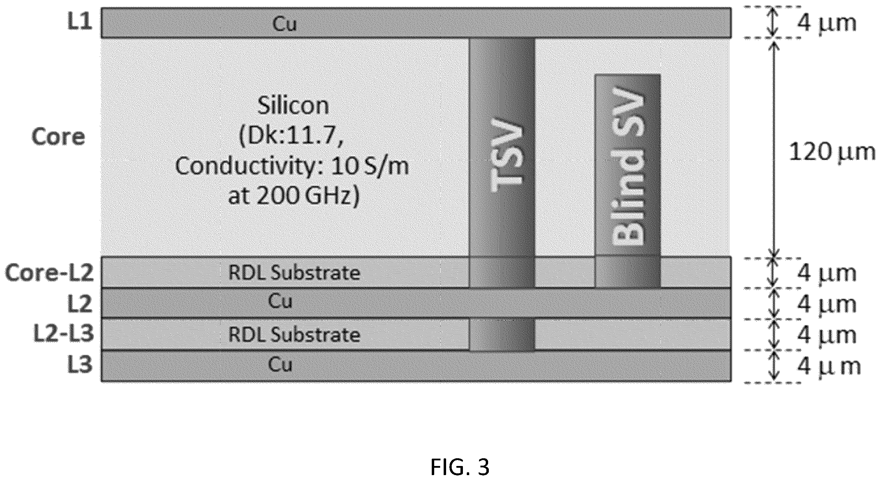

As used throughout this disclosure, the "driven via" is the via that provides wireless communications over the channel and may be either a "through via" (e.g., through the glass/silicon core) or a "blind via" (e.g., terminates within the glass/silicon). In either case, one end of the driven via may be connected to the coupler feed (e.g., a co-planar transmission line connected to the transceiver; e.g., received at the "L2" redistribution metal layer in FIG. 3, discussed in more detail below) while the other end of the driven via is open-ended. In this sense, the driven via is electrically open-ended, like a mini antenna. Thus, where the driven via is blind via that terminates in the core, its core-terminating end will be isolated from ground, and where the driven via is a via that traverses the core and/or terminates in a ground layer, there must be a void surrounding the via in the ground layer(s) so as to isolate the driven via from ground.

Each coupler is also backed by or surrounded by a group of grounded through-hole vias (e.g., also called TSVs, if monolithic silicon die is used) that traverse the core and connect to ground.

The shape/pattern of the surrounding grounded through-hole vias and pitch between them may be optimized to broaden the operational bandwidth and increase isolation levels between adjacent couplers. An optimization algorithm, such as a genetic algorithm, a particle swarm optimization, a CMA-ES (covariance matrix adaptation evolutionary strategy), etc. may be used to determine the shape/pattern and pitch of the grounded through-hole vias that surround the driven via. An array of channels/couplers may be arranged horizontally (x or y-plane) and/or vertically (z direction), e.g., 2 × *m* (horizontal) × *n* (vertical) array, to increase the aggregated throughputs. A desirable stream-to-stream isolation between channels may be > 35 dB for the data aggregation.

FIG. 3 shows an example stack-up of the edge coupler formed from a stack of layers that surround a core, where the core may be silicon/glass and the layers surrounding the core may be alternating layers of metal (e.g., copper) and redistribution layers (RDLs). While the example of FIG. 3 shows a silicon core with a dielectric constant of 11.7 and a conductivity at 200 GHz of 10 S/m, other core materials may be used with different dielectric constants and conductivities, depending for example on the desired range of operating frequencies. As should be understood, the depicted dimensions, number of layers, and types of materials are merely exemplary, and other dimensions, numbers of layers, and materials may be used.

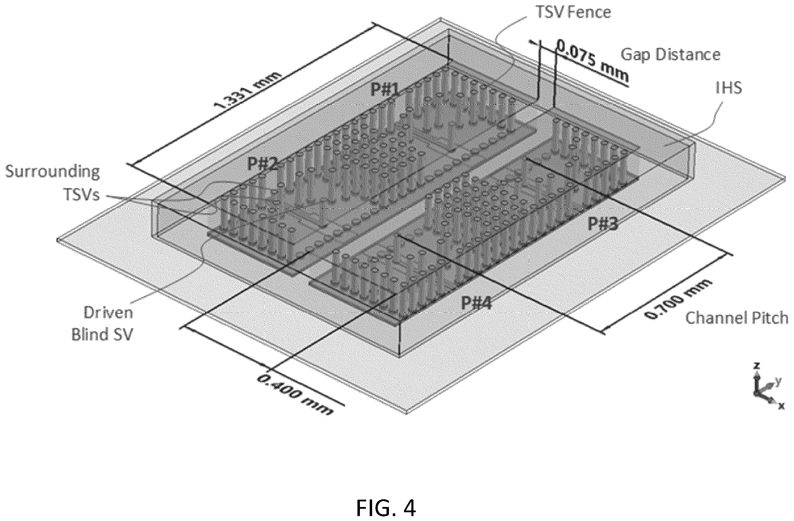

FIG. 4 shows example geometry and dimensions of a two-component system, where each component has two edge couplers for communicating over two channels between the two components. The first component has edge couplers P#1 and P#2, while the second component has edge couplers P#3 and P#4, where one channel is between P#1 and P#3 and the second channel is between P#2 and P#4. As may be seen in the example of FIG. 4, the pitch between adjacent channels (e.g., from the driven via of one channel to the driven via of the adjacent channel) may be 0.700 mm (e.g., a quarter wavelength at the lowest operational frequency), the gap between edges of the components may be 0.075 mm, the overall component length (along the coupling edge of the component) may be 1.331 mm, and the component width (transverse to the coupling edge of the component) may be 0.400 mm. As may be seen in FIG. 4, a semicircle of grounded through-hole vias (TSVs) surround each of the driven vias and a fence of TSVs line the edges of the component that are not the coupling edge (e.g., the edge along which the driven via communicates over a channel, facing the complementary channel edge of the other component). One or both components may be surrounded by an integrated heat sink (IHS). As should be understood, the depicted dimensions and layout are merely exemplary, and other dimensions and layouts may be used. As noted above, the shape of the surrounding grounded through-hole vias may be optimized and be different shapes such as an elliptical shape, a free-formed curve, an arc, a parabola, a zig-zag shape, an angled V-shape, a U-shape, a C-shape, etc.

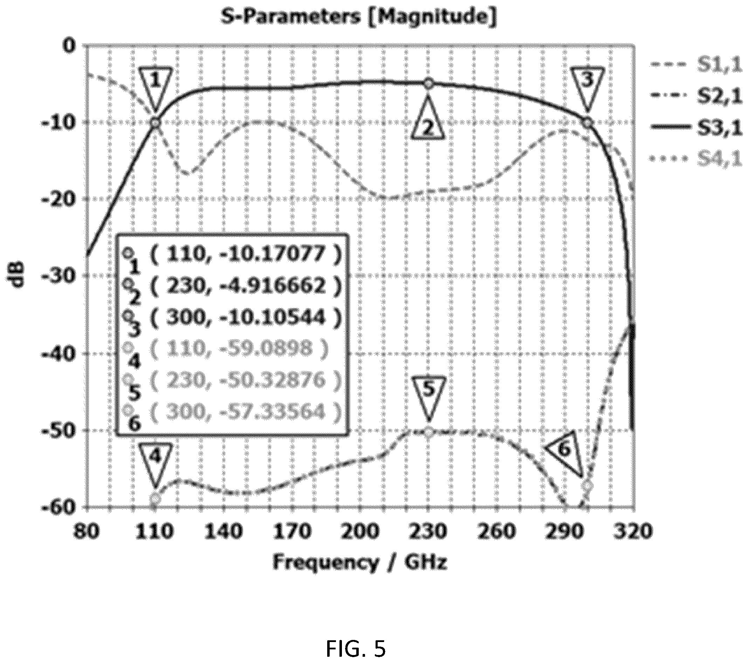

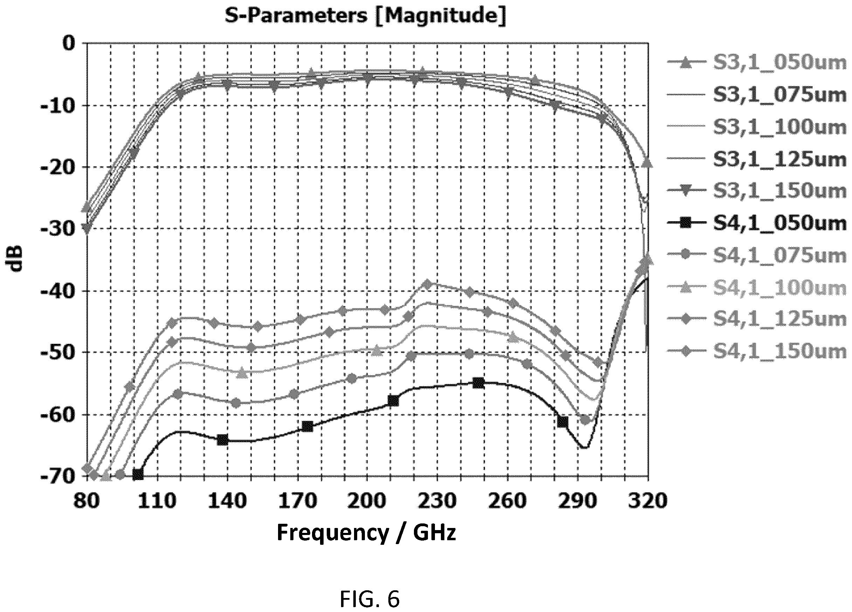

FIG. 5 shows simulation results of the silicon-based 2x2x1 (2 devices, each with 2 channels horizontal in a single vertical stack) direct proximity couplers of FIG. 4 for chiplet-to-chiplet communication under an IHS. The simulation results show > 190 GHz operational bandwidth (entire G-band coverage) with < 10 dB channel loss (where the loss may be mainly due to high silicon conductivity of 10 S/m), > 10 dB return loss within the G-band, and > 40 dB crosstalk suppression between adjacent channels. These simulation results may indicate that such high-isolation direct-proximity-coupling chiplet-to-chiplet channels may be pseudo-independent and scalable for data throughput aggregation. FIG. 6 shows parametric simulation results of gap distance versus channel loss versus isolation for the setup in FIG. 4, which shows that isolation level reduction rate is faster than that of channel loss increase rate as gap distance increases.

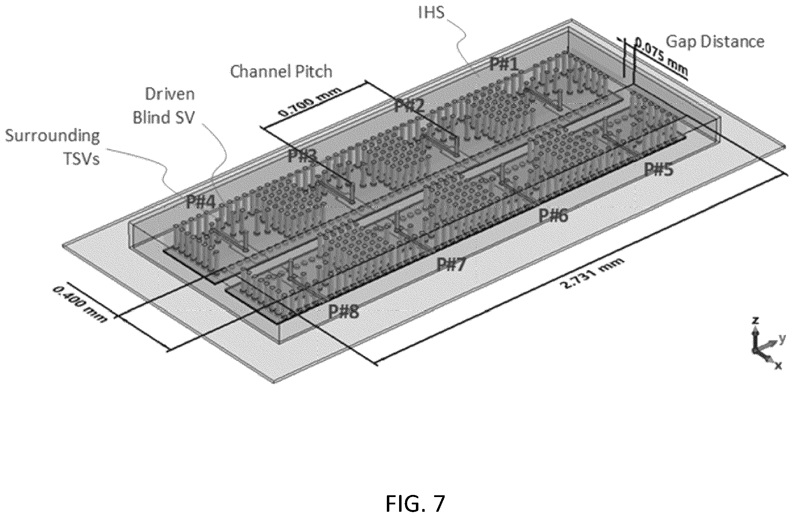

FIG. 7 shows example geometry and dimensions of a two-component system, where each component has four edge couplers for communicating over four channels between the two components. The first component has edge couplers P#1, P#2, P#3, and P#4 while the second component has edge couplers P#5. P#6, P#7, and P#8, where one channel is between P#1 and P#5, the second channel is between P#2 and P#6, the third channel is between P#3 and P#7, and the fourth channel is between P#4 and P#8. As may be seen in the example of FIG. 7, the pitch between adjacent channels (e.g., from the driven via of one channel to the driven via of the adjacent channel) may be 0.700 mm, the gap between edges of the components may be 0.075 mm, the overall component length (along the coupling edge of the component) may be 2.731 mm, and the component width (transverse to the coupling edge of the component) may be 0.400 mm. As may be seen in FIG. 7, a semicircle of grounded through-hole vias (TSVs) surround each of the driven vias and a fence of TSVs line the edges of the component that are not the coupling edge (e.g., the edge along which the driven via communicates over a channel, facing the complementary channel edge of the other component). One or both components may be surrounded by an integrated heat sink (IHS). As should be understood, these dimensions and layout are merely exemplary, and other dimensions and layouts may be used.

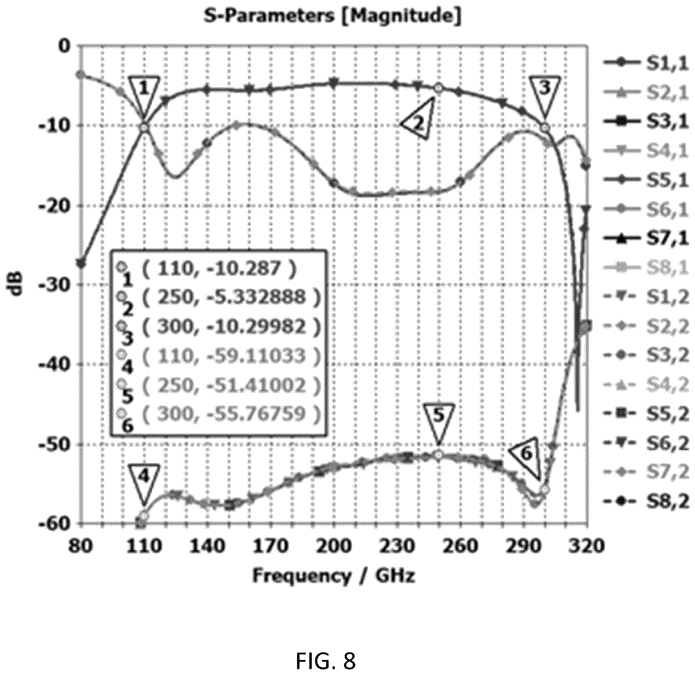

FIG. 8 shows simulation results of the 2x4x1 (2 devices, each with 4 horizontal channels in a single vertical stack) direct proximity coupler array of FIG. 7 under integrated heatsink (IHS). Comparing FIG. 6 to FIG. 8 demonstrates the straightforward scalability both horizontally and vertically (e.g., this type of edge coupler architecture may be configured as 2 × *m* × *n* coupler array, where *m* indicates the number of horizonal channels of the component and n indicates the number of vertically stacked channels. Notice that the 700 µm channel pitch of the 2x4x1 coupler array is the same as that of the 2x2x1 coupler array. In other words, the one element coupler structure may be used as a unit cell that is duplicated side-by-side (horizontally) and/or stacked (vertically) with the same channel pitch to adjacent channels for the desired number of channels. For example, a D-band transceiver may achieve > 150 GHz data throughput for a single channel. Thus, if placing multiple channels side-by-side to form a coupler array with *m* couplers, the aggregated total data throughput may be *m* × 150 Gbps. The simulation results of FIG. 8 for the G-band (110 - 300 GHz) show < -40 dB crosstalk between adjacent channels, supporting the pseudo-independent characteristics of the coupler array architecture.

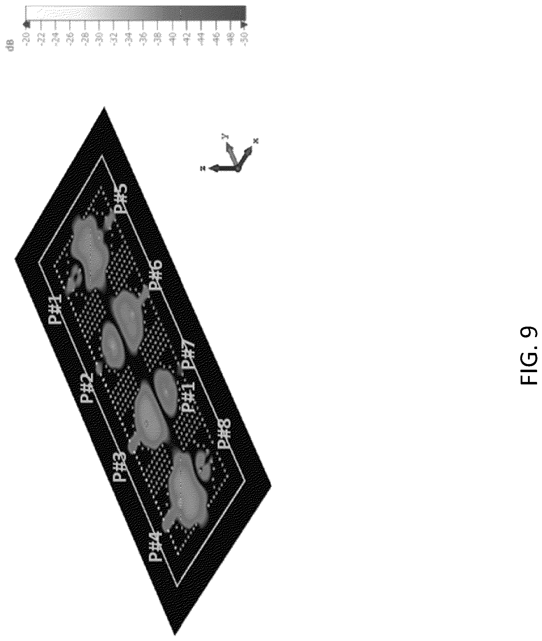

FIG. 9 shows a simulated electric-field distribution of the 2x4x1 direct proximity coupler array of FIG. 7 under integrated heatsink (IHS) at 200 GHz, using simultaneous 4-port excitation (e.g., P#1:L+45°, P#2:L+90°, P#3:Z+135°, P#4:Z+180°) at 200 GHz. Again, as may be observed in the simulation, each channel appears to operate pseudo-independently, supporting the straightforward scalability of channel extensions.

As indicated in the example multi-channel arrays above, a 700 µm channel pitch (e.g., the distance between coupler centers or distance between driven vias of adjacent couplers) was used, which is approximately a one quarter wavelength of the lowest operational frequency of the G-band, which is twice the typical pitch between element antennas in phased antenna array. Whereas the isolation level between element antennas in phased antenna array with half wavelength pitch often shows 15 - 20 dB, the multi-channel edge coupling arrays may have 50 dB isolation (or > 40 dB stream-to-stream crosstalk isolation) between adjacent couplers, which may be a significant improvement over phased antenna arrays.

While the examples and simulations of FIGs. 4-9 were for edge couplers with silicon-based cores (and thus designed for the G-band for chiplet-to-chiplet designs), a glass-based core may be used (and thus targeting D-band operations). Glass-based D-band direct proximity coupling channels may be advantageous for inter-package, inter-PCB, and inter-module communications. Although crosstalk performance is similar to that of silicon-based edge couplers, discussed above for example with respect to FIGs. 4-9, the overall channel loss of glass-based edge couplers may be noticeably lower than that of silicon-based edge couplers due to the relatively lower dielectric loss of glass.

In terms of an architectural perspective, the glass-based edge couplers may not have an IHS (e.g., there is no ground layer that covers package) for package-to-package, PCB-to-PCB, and module-to-module channels. Thus, there may be leaked currents from the open aperture that may flow to adjacent channels. This leaked current may result in a lower isolation level between adjacent channels, which may make it practically challenging to achieve higher total data throughput through data aggregation because channels may be correlated (or not pseudo independent) to each other.

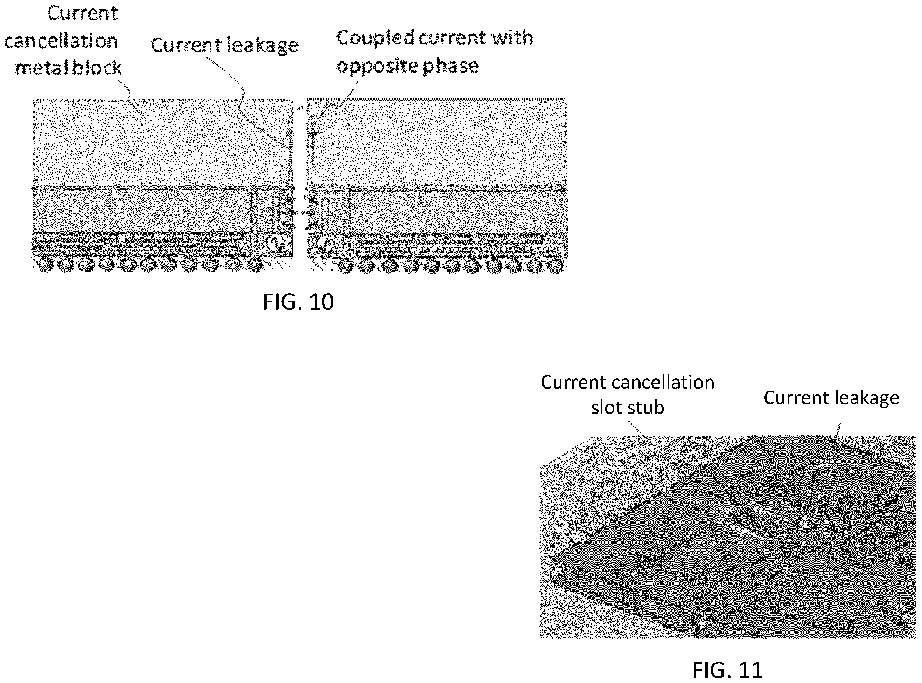

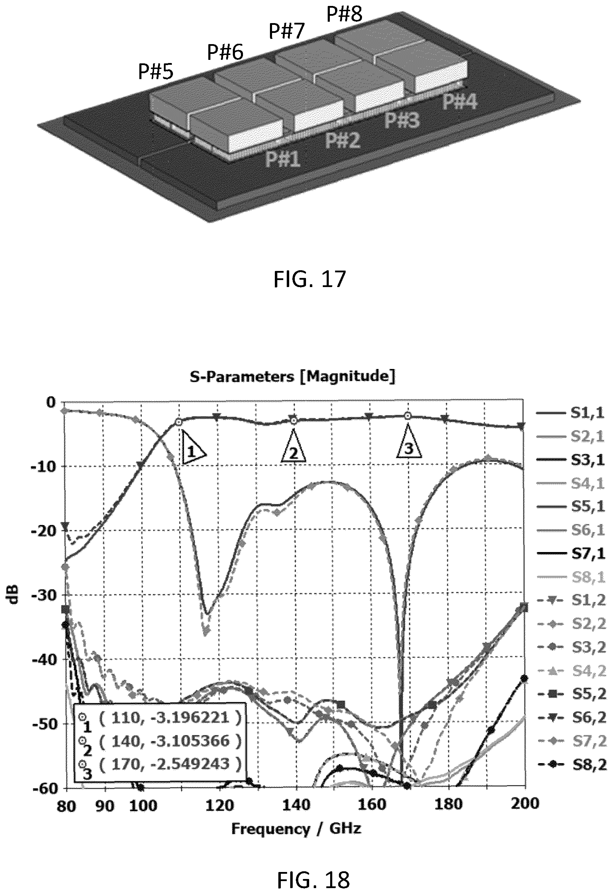

To address the current leakage issue, a current cancellation approach may be used, which enforces high isolation (> 40 dB) between adjacent direct proximity coupling channels. The current cancelation approach may include one of two operational mechanisms: (1) a vertical (z-axis) current cancellation through the use of a top metal block and/or (2) a horizontal current cancellation through the use of a slot stub on ground metal layers between couplers. FIGs. 10 and 11 visually show how each of these solutions may provide current cancelation for the disclosed edge couplers on two components. For vertical current cancellation, as shown in FIG. 10, the leaked currents from the driven blind glass via are toward the top metal block on the driven-side coupler (or Tx coupler on one component) which are electromagnetically coupled to the receiving-side coupler (e.g., the coupler on the other side of the channel on the other component) (e.g., the Rx coupler). The coupled currents flow down through the top metal block on the receiving-side coupler toward the Rx driven via, but before the coupled current reaches and couples into the Rx driven via, it is canceled out because the leaked current (on the driven-side coupler) and the coupled currents (on the receiving-side coupler) have opposite phases. In addition, the current cancellation mechanism may also prevent the leaked currents coupled to the top metal block on the receiving-side from coupling to the Rx driven vias of adjacent channels. This is discussed in more detail below with respect to the example of FIG. 17.

For horizonal current cancellation, shown in FIG. 11, the leaked currents are along the slot stubs in each coupler on the same component, which means that the leaked current (along the stub on the driven-side coupler) has an opposite phase to the coupled current (along the stub on the adjacent-side coupler). Thus, in similar manner to the vertical leaked currents, the horizontal leaked currents are cancelled out around the employed slot stubs on metal layers.

Because the above-described current cancellation may provide high isolation, the disclosed edge couplers may not only empower seamless data throughput aggregation for inter-package, inter-module, and inter-PCB contactless communications, but they may also provide a type of vertical contactless broadcasting channel as well as point-to-point channels when chiplet arrays are stacked vertically. Various examples of such designs of vertically stacked chiplet arrays are discussed in more detail below.

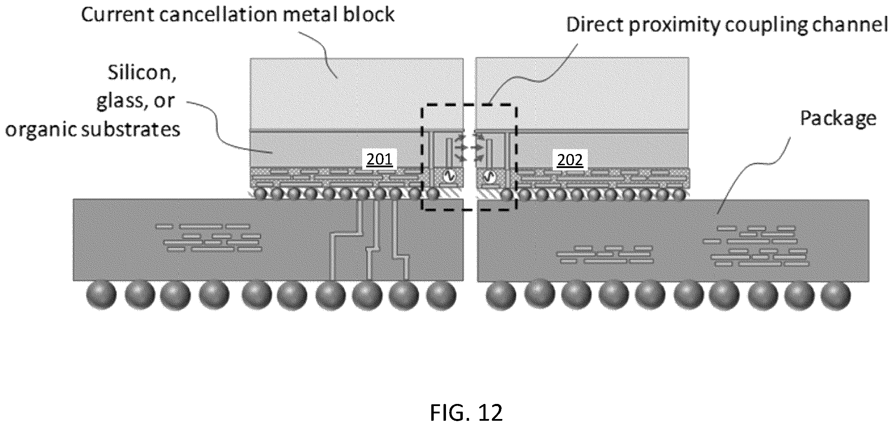

FIG. 12 shows an overall cross-sectional view of a direct proximity coupling channel between two vertically polarized contactless couplers, each of which use a single driven via surrounded by grounded through-hole vias in a monolithic die of silicon, glass, or another organic substrate. The top metal blocks on each coupler may provide leakage current cancelation.

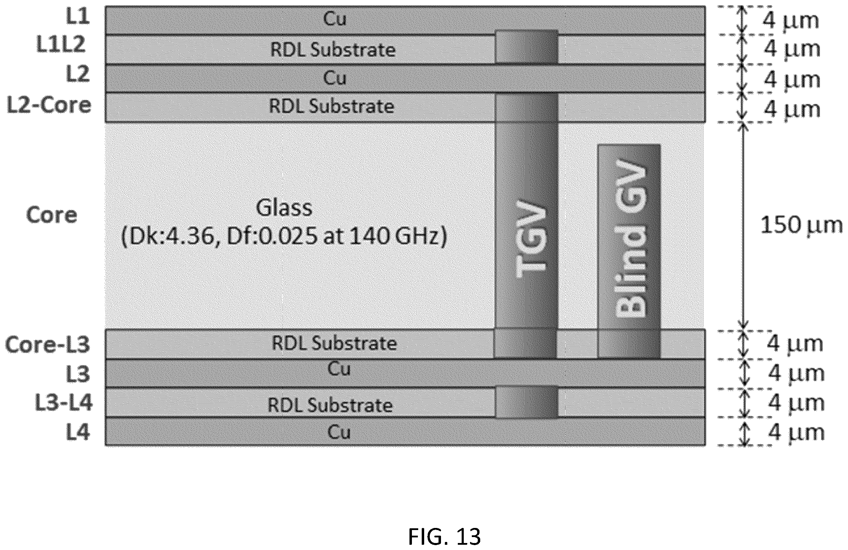

FIG. 13 shows an overall stack-up of glass-based core example, where the stack-up may be used in a vertically polarized coupler for D-band, direct proximity channel coupling, assuming a wafer-level fabrication process. The core may be glass that is 150 µm thick with a dielectric constant of 4.36, a dissipation factor of 0.025 at 140 GHz, though other thicknesses of glass and other glasses with different dielectric constant and/or dissipation factor may be used, depending for example on the desired range of operating frequencies. A stack of layers that surrounds the core may be alternating layers of metal (e.g., copper) and redistribution layers (RDLs) of about 4 µm thick. The driven via may be isolated from ground and surrounded by grounded through-hole vias (because the core is glass, through-glass vias or TGVs) as discussed above. As should be understood, these dimensions and number of layers are merely exemplary, and other dimensions and numbers of layers may be used.

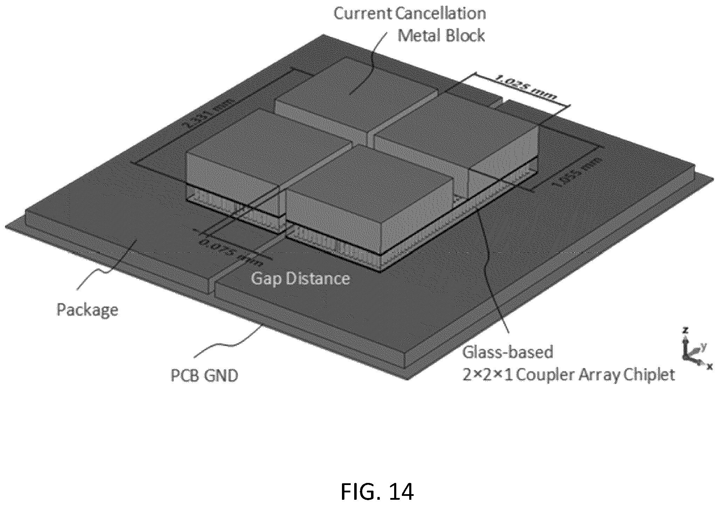

FIG. 14 shows a 2x2x1 array of glass-based direct proximity couplers (e.g., 2 packages, each with 2 channels horizontal in a single vertical stack), where each coupler is covered on the top layer with a current cancelation metal block. The overall coupler array length (along the coupling edge of package) may be 2.331 mm. The length of each coupler in the array (along the coupling edge of package) may be 1.055 mm and the width of the coupler (transverse to the coupling edge of the package) may be 1.025 mm. The adjacent couplers on a given package may be separated by about 0.221 mm, and the gap between packages (e.g., between adjacent couplers that form a given channel between packages) may be 0.075 mm. As should be understood, these dimensions and layouts are merely exemplary, and other dimensions and layouts may be used.

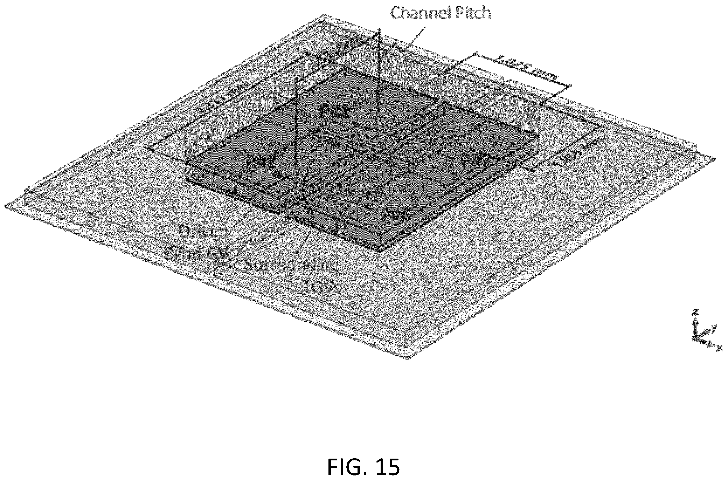

FIG. 15 shows the 2x2x1 array of glass-based direct proximity couplers of FIG. 14, but with the top metal layer shown as transparent to reveal the driven blind via (BGV) and grounded through-hole vias (TGVs) that surround the driven via of each coupler.

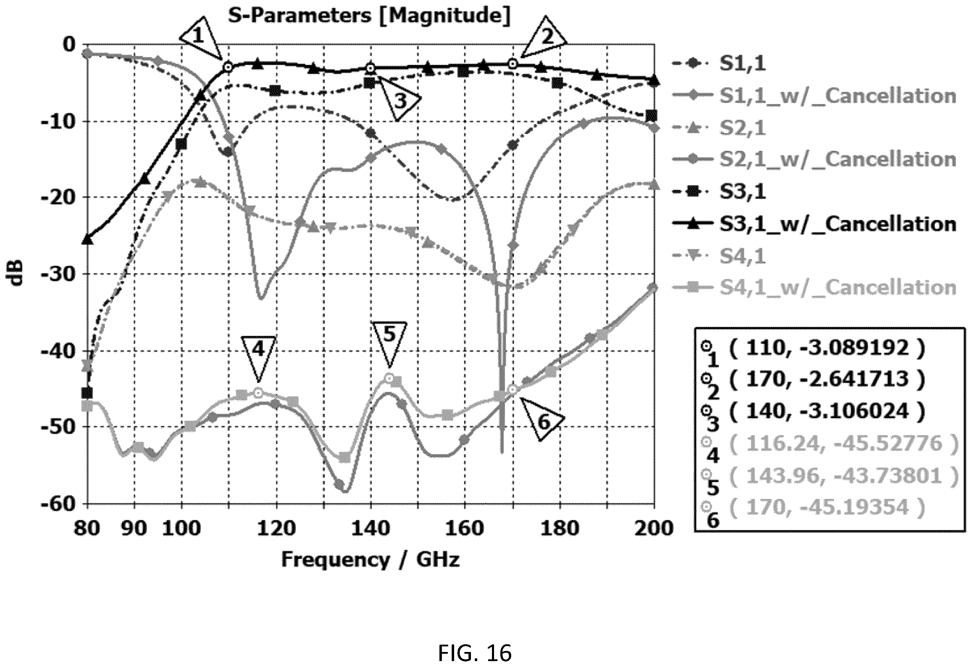

FIG. 16 shows simulation results for s-parameters of 2x2x1 array of glass-based direct proximity couplers, one with and one without the leakage current cancellation features discussed above (e.g., the coupler with leakage current cancellation has a top metal block and (for vertical cancelation) and slot subs (for horizontal cancelation). As may be seen in FIG. 16, the stream-to-stream isolation for couplers with the current cancellation features have significant performance improvements. For example, at 110 GHz, there is > 25 dB isolation level improvement.

FIG. 17 shows a 2x4x1 array of glass-based direct proximity couplers (e.g., 2 packages, each with 4 channels arranged horizontal in a single vertical stack), where each coupler is covered on the top layer with a current cancelation metal block. The first package has edge couplers P#1, P#2, P#3, and P#4 while the second package has edge couplers P#5. P#6, P#7, and P#8, where one channel is between P#1 and P#5, the second channel is between P#2 and P#6, the third channel is between P#3 and P#7, and the fourth channel is between P#4 and P#8. Using the 2x4x1 array in Fig. 17 as an example and referencing the current cancelation techniques discussed above, when P#3 is used as the Tx and P#7 is the Rx (e.g., P#3 and P#7 form a point-to-point channel). At the same time, P#4 may be used as the Tx to form a point-to-point communication channel with P#8 as the Rx. The P#4 to P#8 channel and the P#3 to P#7 channel are adjacent/neighboring channels to one another.

If there were no vertical current cancellation mechanism in the structure of FIG. 17 (e.g., , the top metal blocks were removed), leakage current may be coupled onto the Rx (P#7) which combines constructively/destructively with the directly coupled current of the channel (e.g., from the Tx (P#3)) over the operational frequency range. This may result in a non-flat channel link response and non-flat group delay, which may require a more complicated equalizer and may lower achievable data throughputs.

If there were no horizontal cancellation mechanism (e.g., no metal stubs), leakage current may also couple onto the Rx (P#7) from adjacent channels (e.g., from the Rx (P#8) of the P#4 to P#8 channel or from the Rx P#6 from a P#2 to P#6 channel), which may result in lowering the isolation level.

FIG. 18 shows example simulation results for the 2x4x1 array of glass-based (e.g., for the D-band of 110 - 170 GHz) direct proximity couplers of FIG. 17. The results indicate a < -40 dB crosstalk between adjacent channels. This example demonstrates the pseudo-independent characteristics of the glass-core-based coupler array architecture, having a high isolation level between adjacent couplers. Thus, data aggregation may be achieved when aggregating multiple channels of the coupler array for data throughput.

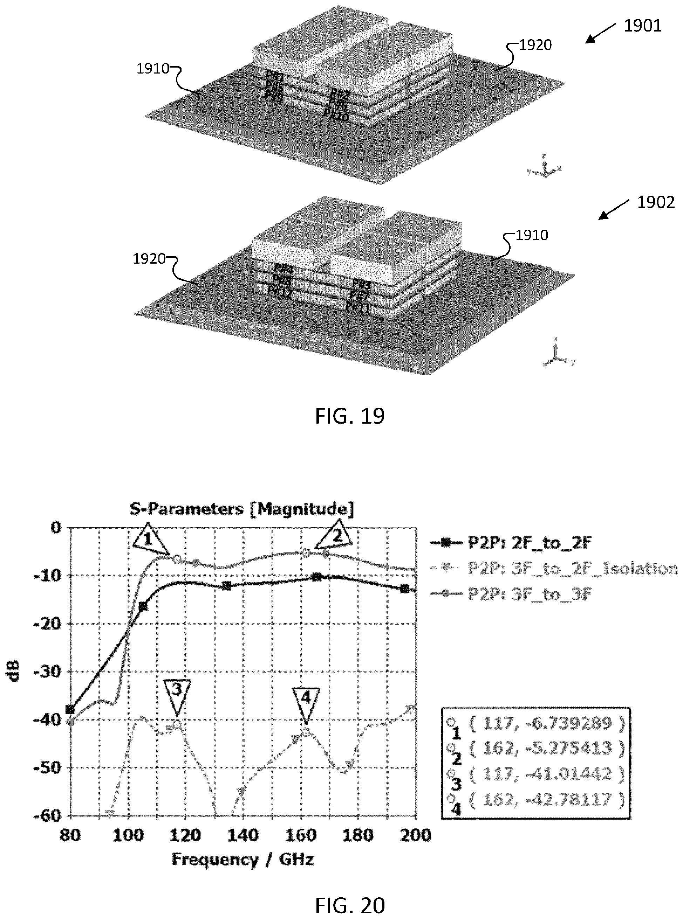

FIG. 19 shows two views of a 2x2x3 array of glass-based direct proximity couplers (e.g., 2 packages, each with 2 channels arranged horizontally and 3 channels stacked vertically), where each stack of couplers is covered on the top with a current cancelation metal block. In view 1901, the first package 1910 is visible in front of second package 1920. In view 1902, it is rotated by 180 degrees around the z-axis so that the second package 1920 is visible in front of the first package 1910. As seen in view 1901, the first package 1910 has edge couplers in two stacks of three, where the top horizontal layer of stack includes edge couplers P#1 and P#2, the middle horizontal layer of the stack includes edge couplers P#5 and P#6, and the bottom horizontal layer of the stack includes edge couplers P#9 and P#10.

As seen in view 1902, the second package 1920 also has edge couplers in two stacks of three, where the top horizontal layer of stack includes edge couplers P#4 and P#3, the middle horizontal layer of the stack includes edge couplers P#8 and P#7, and the bottom horizontal layer of the stack includes edge couplers P#12 and P#11. Such a configuration may support either point-to-point communications between two couplers (e.g., horizontal pairs) or broadcast communications from one coupler to multiple couplers (e.g., within a vertical column). Thus, an example of a point-to-point communication for a horizontal pair would be between P#1 of the first package 1910 and P#3 of the second package 1920 or between P# 10 of the first package 1910 and P#12 of the second package 1920. Similarly, an example of a broadcast communication for a vertical stack would be between P#1 of the first package 1910 and P#3, P#7, and P#11 of the second package 1920.

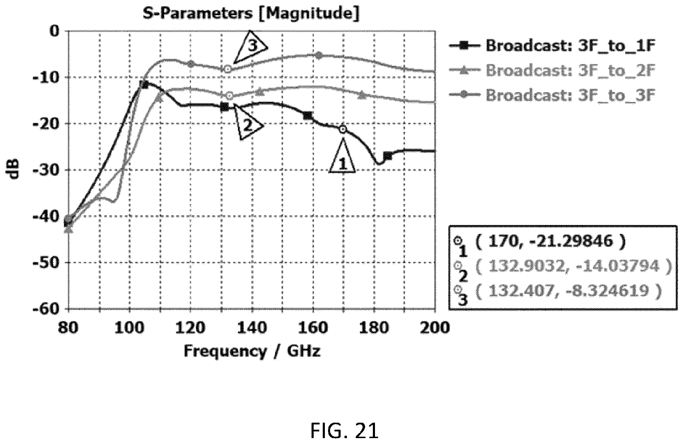

FIG. 20 shows simulation results for the 2x2x3 glass-core-based direct proximity couplers of FIG. 19 for point-to-point communications and FIG. 21 simulation results for the 2x2x3 glass-core-based direct proximity couplers of FIG. 19 for broadcast communications.

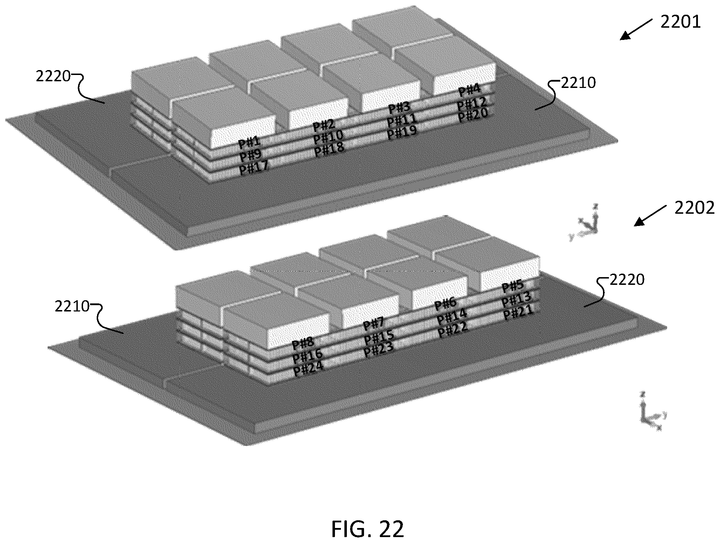

FIG. 22 shows two views of a 2x4x3 array of glass-core-based direct proximity couplers (e.g., 2 packages, each with 4 channels arranged horizontally and 3 channels stacked vertically), where each stack of couplers is covered on the top with a current cancelation metal block. In view 2201, the first package 2210 is visible in front of second package 2220. In view 2202, it is rotated by 180 degrees around the z-axis so that the second package 2220 is visible in front of the first package 2210. As seen in view 2201, the first package 2210 has edge couplers in four stacks of three, where the top horizontal layer of stack includes edge couplers P#1, P#2, P#3, and P#4, the middle horizontal layer of the stack includes edge couplers P#9, P#10, P#11, and P#12, and the bottom horizontal layer of the stack includes edge couplers P#17, P#18, P#19, and P#20.

As seen in view 2202, the second package 2220 has edge couplers in four stacks of three, where the top horizontal layer of stack includes edge couplers P#8, P#7, P#6, and P#5, the middle horizontal layer of the stack includes edge couplers P#16, P#15, P#14, and P#13, and the bottom horizontal layer of the stack includes edge couplers P#24, P#23, P#22, and P#21. As with the 2x2x3 of FIG. 19, the 2x4x3 configuration of FIG. 22 may support either point-to-point communications between two couplers (e.g., horizontal pairs) or broadcast communications from one coupler to multiple couplers (e.g., within a vertical column).

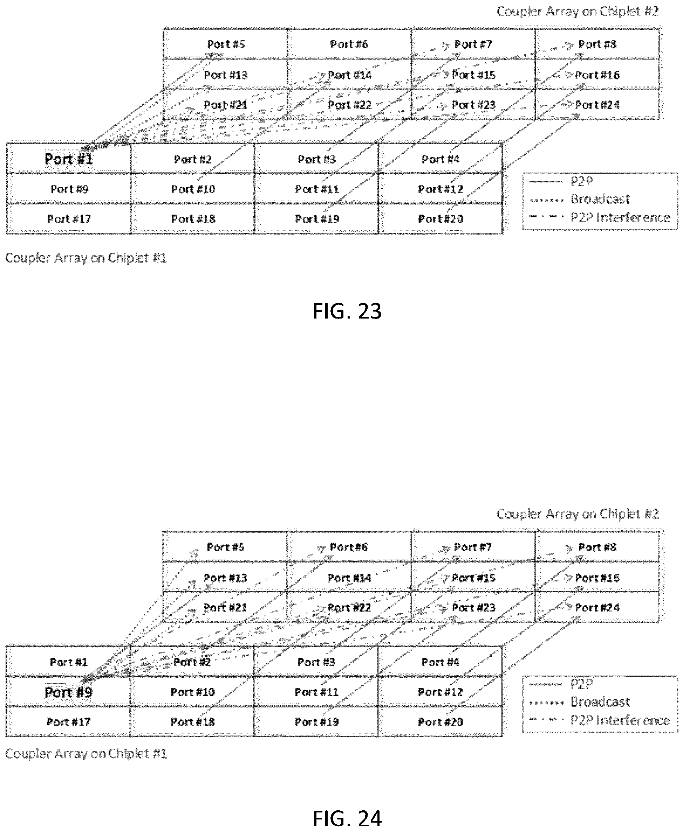

FIGs. 23 and 24 shows various examples of the communication capabilities of the 2x4x3 array of FIG. 22 for point-to-point communications or broadcast communications, as well as the point-to-point interference that may result from such communications. For example, in FIG. 23, when P#1 (Port #1) of one package is driven for point-to-point communications with complimentary P#5 (Port #5) of the other package or is driven for broadcast communications with the complimentary stack of P#5, P#13, and P#21, there may be point-to-point interference (P2P Interference) from Port #1 that impacts other channels on the other package, such as P#14 (Port #14), P#22 (Port #22), P#7 (Port #7), P#15 (Port #15), P#23 (Port #23), P#8 (Port #8), P#16 (Port #16), or P#24 (Port #24). As another example, in FIG. 24, when P#9 (Port #9) of one package is driven for point-to-point communications with complimentary P#13 (Port #13) of the other package or is driven for broadcast communications with the complimentary stack of P#5, P#13, and P#21, there may be point-to-point interference (P2P Interference) from Port #9 that impacts other channels on the other package, such as P#16 (Port #6), P#22 (Port #22), P#7 (Port #7), P#15 (Port #15), P#23 (Port #23), P#8 (Port #8), P#16 (Port #16), or P#24 (Port #24). As should be understood, a communication protocol may be used for communications to encode data in higher communication layers so that each port may detect/recover, even with the P2P interference, its intended communication signal.

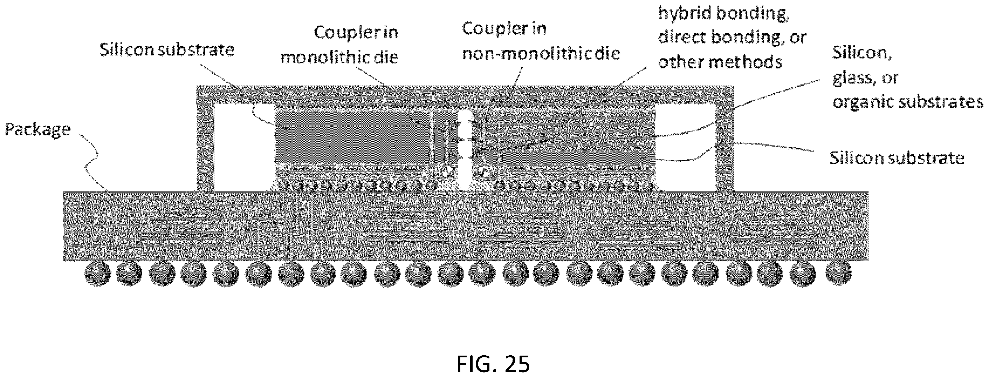

FIG. 25 shows an example of a direct proximity coupling channel between a coupler formed in a monolithic die and coupler formed in non-monolithic die. As should be understood, the direct proximity channel may be formed between two couplers, each formed in a non-monolithic die.

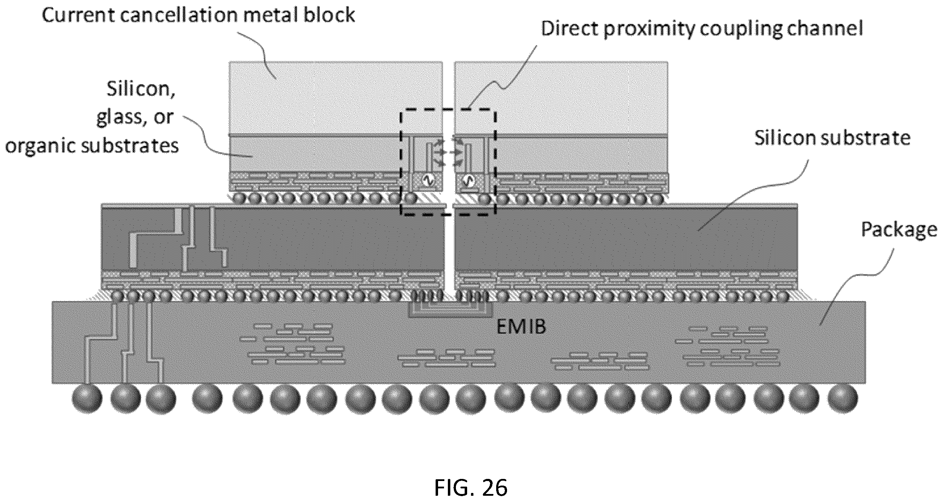

FIG. 26 shows an example of a direct proximity coupling channel variant for die-to-die communications, where the couplers' transmission channels are between dies that are formed on a common substrate.

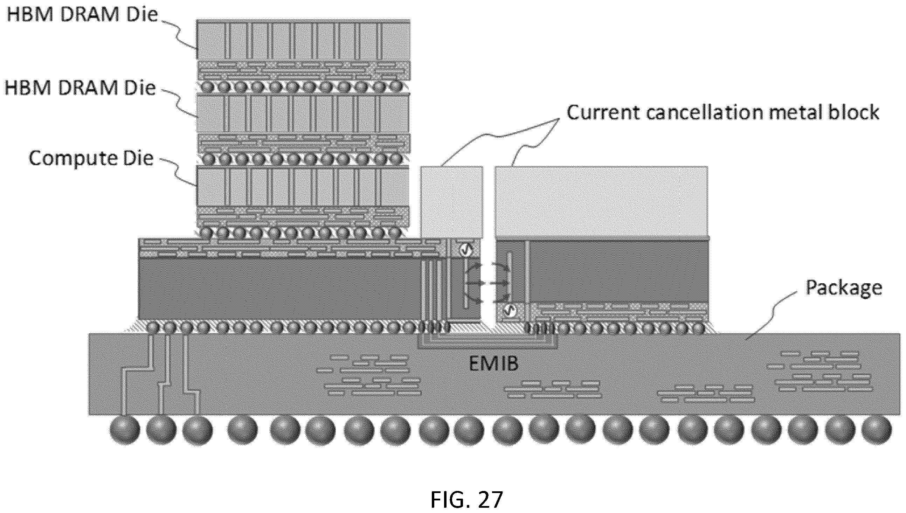

FIG. 27 shows an example of a 3D heterogeneous chiplet integration of a direct proximity coupling channel with a 3D stacked package of HBM DRAM dies and a compute die, together with a package architecture supporting Foveros^{®} and EMIB.

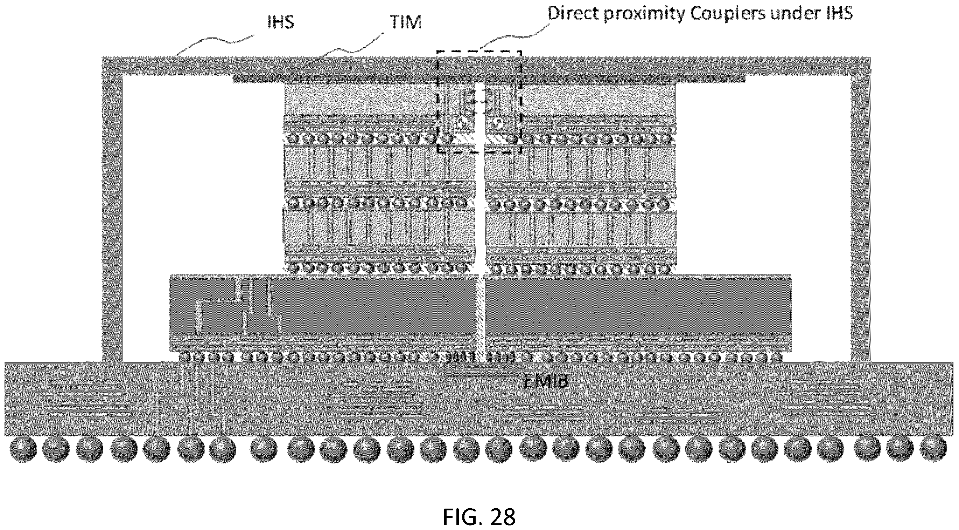

FIG. 28 shows an example 3D heterogeneous chiplet integration of a direct proximity coupling channel and EMIB in the package, where the couplers are under a common integrated heatsink (IHS) that may contact the chiplets through a thermal interface material (TIM). The direct proximity coupling channel may reduce the communication latency between left top die and right top die, compared to the communication link through the EMIB in the package.

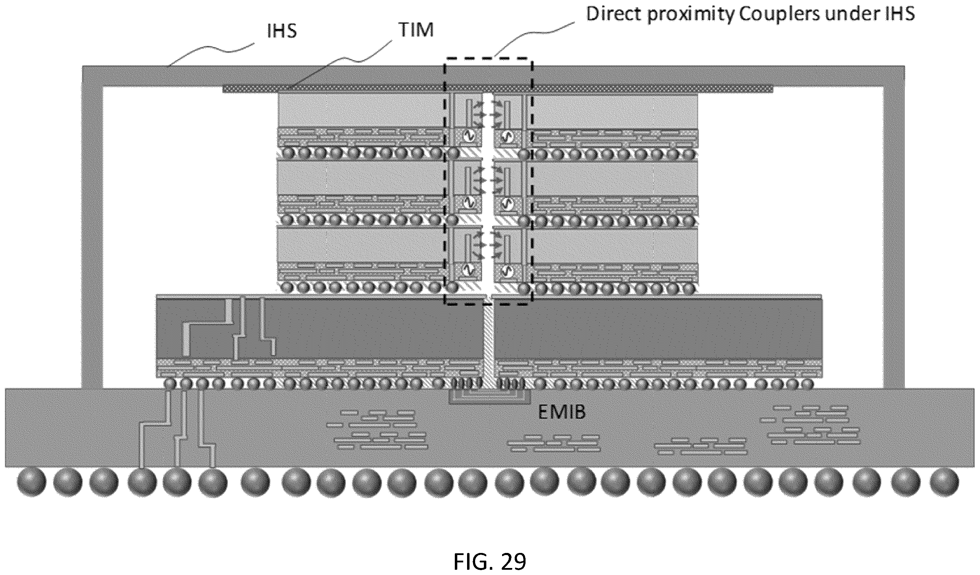

FIG. 29 shows an example 3D heterogeneous chiplet integration of a stacked direct proximity coupling channels and EMIB in the package, where the couplers are under a common integrated heatsink (IHS) that may contact the chiplets through a thermal interface material (TIM).

In the following, various examples are provided that may include one or more features of the disclosed couplers discussed above. It may be intended that aspects described in relation to the devices may apply also to the described method(s), and vice versa.

Example 1 is a contactless edge coupler for communicating between edges of device packages, the contactless edge coupler including a stack of multiple layers; a core arranged between layers of the stack; a driven via that extends from at least one feed layer of the stack of multiple layers into the core, wherein the driven via is isolated from ground; and a plurality of grounded through-hole vias that extend from at least one ground layer of the stack and traverse through the core, wherein the plurality of grounded through-hole vias partially surround the driven via.

Example 2 is the contactless edge coupler of example 1, wherein the plurality of grounded through-hole vias are spaced apart from one another and partially surround the driven via in a pattern around the driven via, wherein the pattern leaves open at least an edge portion of the contactless edge coupler.

Example 3 is the contactless edge coupler of example 2, wherein the pattern forms a semicircle shape, an elliptical shape, a free-formed curve, an arc, a parabola, a zig-zag shape, an angled V-shape, a U-shape, or a C-shape around the driven via.

Example 4 is the contactless edge coupler of any one of examples 2 to 3, wherein the contactless edge coupler is arranged on an edge of a device package

Example 5 is the contactless edge coupler of example 4, wherein preferably the device package includes a microchip package, an integrated circuit package, a semiconductor package, a microcontroller package, a system-on-chip package, or a memory chip package.

Example 6 is the contactless edge coupler of example 4, wherein the at least the edge portion of the contactless edge coupler is left open at the edge of the device package for communicating wirelessly with other device packages by means of the driven via.

Example 7 is the contactless edge coupler of any one of examples 1 to 6, further including a metal block on top of the stack of multiple layers, wherein preferably the metal block is thicker than each layer in the stack of multiple layers.

Example 8 is the contactless edge coupler of any one of examples 1 to 7, the contactless edge coupler further including a metal slot that extends from at least one ground layer of the stack and traverses through the core, wherein preferably the metal slot is spaced further away from the driven via than the plurality of grounded through-hole vias, wherein preferably the metal slot is arranged on an edge of a device package in which the contactless edge coupler is mounted.

Example 9 is the contactless edge coupler of any one of examples 1 to 8, wherein the stack of multiple layers includes a first layer stack that is stacked above the core and a second layer stack that is stacked below the core.

Example 10 is the contactless edge coupler of any one of examples 1 to 9, wherein the stack of multiple layers includes alternating layers of a substrate layer and a metal layer.

Example 11 is the contactless edge coupler of and one of examples 1 to 10, wherein the driven via terminates within the core.

Example 12 is the contactless edge coupler of any one of examples 1 to 11, wherein the driven via is configured to direct transmissions of communication signals from the driven via towards a transmission region that is away from the plurality of grounded through-hole vias that partially surround the driven via and to direct receptions of communication signals from the transmission region towards the driven via.

Example 13 is the contactless edge coupler of example 12, wherein the transmission region is along an edge of the contactless edge coupler.

Example 14 is the contactless edge coupler of any one of examples 1 to 13, wherein the contactless edge coupler is mounted in a device package along with a second edge coupler, wherein the contactless edge coupler is adjacent to and spaced apart from the second edge coupler by an open gap, wherein the contactless edge coupler is configured to communicate wirelessly across the open gap with the second edge coupler.

Example 15 is the contactless edge coupler of example 14, wherein the contactless edge coupler and the second edge coupler are covered by and in contact with a heat spreader, wherein preferably a thermal interface material is disposed between a top of the contactless edge coupler and a second top of the second edge coupler, wherein the heat spreader is in physical contact through the thermal interface material with the top of the contactless edge coupler and the second top of the second edge coupler.

Example 16 is the contactless edge coupler of any one of examples 14 to 15, wherein the contactless edge coupler is configured to direct wireless transmissions of signals from the driven via towards a second driven via of the second edge coupler along a transmission channel.

Example 17 is a chip-to chip coupling system for communicating between edges of device packages, the chip-to chip coupling system including a first device package including a first coupler on a first edge of the first device package and a second device package including a second coupler on a second edge of the second device package. The first edge is adjacent to and spaced apart from the second edge by an open gap, wherein the first coupler and the second coupler are configured to communicate wirelessly across the open gap. Each of the first and second couplers includes a stack of multiple layers; a core arranged between layers of the stack; a driven via that extends from at least one feed layer of the stack of multiple layers into the core, wherein the driven via is isolated from ground; and a plurality of grounded through-hole vias that extend from at least one ground layer of the stack and traverse through the core, wherein the plurality of grounded through-hole vias partially surround the driven via.

Example 18 is the chip-to chip coupling system of example 17, wherein the first device package or the second device package includes a microchip package, an integrated circuit package, a semiconductor package, a microcontroller package, a system-on-chip package, or a memory chip package, wherein the first device package and the second device package are mounted on a printed circuit board.

Example 19 is the chip-to chip coupling system of any one of examples 17 to 18, wherein the first device package and the second device package are covered by and in contact with a heat spreader, wherein preferably a thermal interface material is disposed between a top layer of the stack of multiple layers through which the heat spreader is in contact with the first and second device packages.

Example 20 is the chip-to chip coupling system of any one of examples 17 to 19, wherein the driven via of the first device package is configured to direct wireless transmissions of signals from the driven via towards the driven via of the second device package along a transmission channel.

Example 21 is the chip-to chip coupling system of any one of examples 17 to 20, wherein the first device package includes a third coupler on the first edge and spaced apart along the first edge from the first coupler, wherein the second device package includes a fourth coupler one the second edge and spaced apart along the second edge from the second coupler, wherein the third coupler is configured to direct wireless transmissions of signals from a driven via of the third coupler towards a driven via of the fourth coupler a second transmission channel.

Example 22 is the chip-to chip coupling system of example 21, wherein the first transmission channel is spaced apart from the second transmission channel by a minimum pitch of quarter wavelength at the lowest operational frequency.

While the disclosure has been particularly shown and described with reference to specific aspects, it should be understood by those skilled in the art that various changes in form and detail may be made therein without departing from the spirit and scope of the disclosure as defined by the appended claims. The scope of the disclosure is thus indicated by the appended claims and all changes, which come within the meaning and range of equivalency of the claims, are therefore intended to be embraced.

## Claims

1. A contactless edge coupler for communicating between edges of device packages, the contactless edge coupler comprising:
a stack of multiple layers;
a core arranged between layers of the stack;
a driven via that extends from at least one feed layer of the stack of multiple layers into the core, wherein the driven via is isolated from ground; and
a plurality of grounded through-hole vias that extend from at least one ground layer of the stack and traverse through the core, wherein the plurality of grounded through-hole vias partially surround the driven via.

2. The contactless edge coupler of claim 1, wherein the plurality of grounded through-hole vias are spaced apart from one another and partially surround the driven via in a pattern around the driven via, wherein the pattern leaves open at least an edge portion of the contactless edge coupler.

3. The contactless edge coupler of claim 2, wherein the pattern forms a semicircle shape, an elliptical shape, a free-formed curve, an arc, a parabola, a zig-zag shape, an angled V-shape, a U-shape, or a C-shape around the driven via.

4. The contactless edge coupler of any one of claims 2 to 3, wherein the contactless edge coupler is arranged on an edge of a device package, wherein preferably the device package comprises a microchip package, an integrated circuit package, a semiconductor package, a microcontroller package, a system-on-chip package, or a memory chip package.

5. The contactless edge coupler of claim 4, wherein the at least the edge portion of the contactless edge coupler is left open at the edge of the device package for communicating wirelessly with other device packages by means of the driven via.

6. The contactless edge coupler of any one of claims 1 to 5, further comprising a metal block on top of the stack of multiple layers, wherein preferably the metal block is thicker than each layer in the stack of multiple layers.

7. The contactless edge coupler of any one of claims 1 to 6, the contactless edge coupler further comprising a metal slot that extends from at least one ground layer of the stack and traverses through the core, wherein preferably the metal slot is arranged on an edge of a device package in which the contactless edge coupler is mounted.

8. The contactless edge coupler of any one of claims 1 to 7, wherein the stack of multiple layers comprises a first layer stack that is stacked above the core and a second layer stack that is stacked below the core.

9. The contactless edge coupler of any one of claims 1 to 8, wherein the stack of multiple layers comprises alternating layers of a substrate layer and a metal layer.

10. The contactless edge coupler of and one of claims 1 to 9, wherein the driven via terminates within the core.

11. The contactless edge coupler of any one of claims 1 to 10, wherein the driven via is configured to direct transmissions of communication signals from the driven via towards a transmission region that is away from the plurality of grounded through-hole vias that partially surround the driven via and to direct receptions of communication signals from the transition region towards the driven via.

12. The contactless edge coupler of claim 11, wherein the transmission region is along an edge of the contactless edge coupler.

13. The contactless edge coupler of any one of claims 1 to 12, wherein the contactless edge coupler is mounted in a device package along with a second edge coupler, wherein the contactless edge coupler is adjacent to and spaced apart from the second edge coupler by an open gap, wherein the contactless edge coupler is configured to communicate wirelessly across the open gap with the second edge coupler.

14. The contactless edge coupler of claim 13, wherein the contactless edge coupler and the second edge coupler are covered by and in contact with a heat spreader, wherein preferably a thermal interface material is disposed between a top of the contactless edge coupler and a second top of the second edge coupler, wherein the heat spreader is in physical contact through the thermal interface material with the top of the contactless edge coupler and the second top of the second edge coupler.

15. The contactless edge coupler of any one of claims 13 to 14, wherein the contactless edge coupler is configured to direct wireless transmissions of signals from the driven via towards a second driven via of the second edge coupler along a transmission channel.
